# FASCICULE DE BREVET EUROPEEN

(11) **EP 0 313 427 B1**
(45) Date de publication et mention de la délivrance du brevet: **25.01.1995**
(21) Numéro de dépôt: 88402487.8
(22) Date de dépôt: 30.09.1988
(51) Int. Cl.: H01L 27/115, G11C 16/04

(54) **Mémoire en circuit intégré**
Speicher in einer integrierten Schaltung
Memory in integrated circuit

(30) Priorité: 09.10.1987 FR 8713951
(43) Date de publication de la demande: 26.04.1989
(73) Titulaire: SGS-THOMSON MICROELECTRONICS S.A., 94250 Gentilly (FR)
(72) Inventeur: Bergemont, Albert, F-75116 Paris (FR)
(74) Mandataire: Schmit, Christian Norbert Marie

(56) Documents cités:
- EP-A- 0 045 578
- EP-A- 0 164 781
- FR-A- 2 437 676
- GB-A- 2 073 488
- US-A- 4 377 818

## Description

La présente invention a pour objet une mémoire comportant un circuit électronique intégré dans un substrat semiconducteur. Elle concerne plus particulièrement les mémoires dont la cellule mémoire est munie d'un transistor à grille flottante. Elle vise plus particulièrement à augmenter le nombre de cellules mémoires intégrées sur une même pastille, de même que les qualités d'effaçage d'informations qui auraient été programmées dans ces cellules mémoires en vue de les reprogrammer.

Les mémoires dont les cellules mémoires sont munies d'un transistor à grille flottante sont de deux types. Dans un premier type les mémoires sont programmables électriquement mais effaçables seulement optiquement. Pour l'effacement il suffit de soumettre l'ensemble de la mémoire à un rayonnement ultra-violet pendant une durée de l'ordre d'une demi-heure de manière à effacer toutes les informations enregistrées dans les cellules mémoires sous forme de charges électriques stockées dans les grilles flottantes des transistors. Le premier type de mémoire dit EPROM présente deux inconvénients : premièrement ces mémoires ne sont pas effaçables facilement puisqu'il faut attendre une demi-heure pour chaque effacement, ce qui en condamne l'utilisation comme mémoire à accès aléatoire de micro-processeur. D'autre part la soumission aux rayons ultra-violets nécessite l'interposition, au sommet de la pastille, d'une fenêtre en quartz, transparente aux rayons ultra-violets, et qui assure la protection mécanique de la pastille. La réalisation de cette fenêtre est coûteuse. En pratique les mémoires de ce premier type sont alors plutôt utilisées sans fenêtre de quartz, et elles remplacent, dans le domaine des mémoires programmables une seule fois, les mémoires à fusibles où l'information enregistrée est matérialisée par la fonte ou le maintien en l'état d'un fusible (ou d'une jonction fragile d'une diode) placé entre deux lignes de conduction orthogonales.

L'autre type de mémoire munie de transistors à grille flottante dite EEPROM possède des cellules mémoires dont les informations enregistrées peuvent être effacées électriquement. Dans ces mémoires les informations sont rangées octet par octet. Il est même possible de choisir un effacement octet par octet ou un effacement de la totalité de la mémoire. L'effacement octet par octet est préféré pour un usage de ces mémoires comme mémoires à accès aléatoire. Le nombre de cycles écriture-effacement auquel peuvent être soumises les cellules mémoires de ces mémoires est de l'ordre de 100.000. Pratiquement chaque cellule mémoire comporte un transistor à grille flottante, par exemple à canal N et intégré dans un subtrat semiconducteur de type P, dont la source est reliée à un potentiel nul, dont le drain est relié à un potentiel positif alimenté par une ligne de bits et dont la grille de commande, superposée à la grille flottante au-dessus du canal de conduction de ce transistor, est connectée à la ligne de mots orthogonale à la ligne de bits.

De manière à assurer avec efficacité les opérations de programmation et d'effacement, les drains de ces transistors doivent être en fait mis en série avec un transistor de commande. La source du transistor de commande est reliée au drain du transistor à grille flottante et le drain du transistor de commande est effectivement relié à la ligne de bits. La grille de commande du transistor de commande est reliée à une ligne dite de contrôle sur laquelle on applique des potentiels sélectionnés au moment de la programmation. Une description de cellules mémoires de ce type a été récemment présentée par SEEQ au congrés ISSCC de 1987, page 76 du résumé des conférences, dans une intervention intitulée "FLASH EEPROM USING DOUBLE POLYSILICON TECHNOLOGY". Il y est indiqué que pour la programmation d'une cellule mémoire la ligne de bits qui conduit à cette cellule mémoire doit être polarisée avec une tension de l'ordre de 8 volts tandis que la ligne de mot qui aboutit à la grille de commande du transistor à grille flottante de cette même cellule mémoire doit être polarisée avec une tension de l'ordre de 12,5 Volts. La source du transistor à programmer doit être portée à la masse. L'application d'une impulsion sur la ligne de contrôle qui passe par le transistor de commande de la cellule mémoire programmée impose que ces potentiels sont appliqués sur le transistor à grille flottante de cette cellule mémoire. Dans ces conditions le canal de conduction de ce transistor se met en saturation, et l'agitation des porteurs chauds (ici des électrons quand le canal est N) leur donne une énergie suffisante pour que certains de ces porteurs puissent franchir la hauteur d'une barrière Si/Si02 interposée centre le canal de conduction et la grille flottante. De cette manière ils viennent se fixer dans cette grille flottante. Lorsque ces tensions de programmation sont enlevées les électrons piègés dans la grille flottante ne peuvent plus en ressortir puisqu'alors ils ne sont plus soumis qu'à leur agitation propre. Celle-ci est insuffisante à leur conférer suffisament d'énergie pour qu'ils puissent quitter cette grille flottante. Leur présence créé alors un champ électrique de blocage dans le canal de conduction.

Lorsqu'on veut lire cette cellule mémoire on alimente sa ligne de bits par une tension positive, et on envoie une impulsion de lecture sur sa ligne de mot. Le champ électrique créé par l'impulsion électrique sur la ligne de mot est alors insuffisant pour s'opposer au champ électrique créé par les charges piègées de telle manière que l'état de conduction (de blocage) du transistor à grille flottante ainsi programé n'en n'est pas modifié. On en déduit son état de programmation en mesurant, quand il devient passant, que des charges électriques n'ont pas été piègées dans la grille flottante. On exploite dans ce but la chute de tension qui en résulte dans le circuit de polarisation de la ligne de bits concernée. Pour l'effacement il suffit de soumettre les drains et sources des transistors à grilles flottantes à effacer à une tension élevée (par exemple 20 volts), tandis que les lignes de mot aboutissant aux grilles de commande des transistors à grille flottante sont soumises à un potentiel nul. Dans ces conditions un champ électrique inverse puissant s'établit dans le transistor. Ce champ inverse fait migrer les porteurs piégès vers le drain ou la source de ce transistor. En sélectionnant les lignes de contrôle adéquates on peut limiter l'effacement à un nombre limité de cellules mémoires dont les sources des transitors sont reliées entre elles.

Ce deuxième type de mémoire en circuit intégré présente cependant un inconvénient important lié à la présense du transistor de commande. En effet celui-ci occupe de la place dans chaque point mémoire. Ceci limite le nombre de cellule mémoires intégrables sur une même pastille semiconductrice. En pratique, avec des procédés de fabrication de moyenne complexité, on aboutit ainsi à des cellules mémoires dont la taille est de l'ordre de 100 à 150 micromètres carrés. La réduction de la taille de ces cellules mémoires passe par une réduction des surfaces de couplage entre les grilles flottantes et les canaux de conduction des transistors à grille flottante. Cette réduction de la surface de couplage change à un point tel les conditions de conduction du canal de conduction de ce transistor qu'il devient nécessaire de réduire l'épaisseur de l'oxyde de grille, dit oxyde tunnel, en dessous de 80 à 100 angströms (1 angström = 0.1 nm). Or il est très difficile de diminuer cette épaisseur pour deux raisons. D'une part la densité des défauts augmente, et le taux de bonne fabrication baisse. D'autre part la rétention des charges, des électrons, dans les grilles flottantes diminue. En effet du fait de leur agitation propre les électrons refranchissent quand même un peu la barrière constituée par l'épaisseur de l'oxyde de grille. L'information contenue dans le point mémoire s'évanouit alors petit à petit. En pratique cette disparition est estimée être de l'ordre de 10 ans, actuellement. Cependent si l'oxyde grille est réalisé avec une épaisseur réduite cette durée de rétention sera considérablement diminuée. Dans les points mémoire décrit par SEEQ ces inconvénients sont partiellement résolus en réalisant des cellules mémoires dont la grille flottante du transistor à grille flottante est située à l'aplomb et uniquement en dessous d'une grille de commande constituant la ligne de mots. Deux points mémoires adjacents sont placés symétriquement de part et d'autre d'une connexion commune de source reliée, au moment de la lecture, à un potentiel nul. Le mode de connexion propre à cette architecture de point mémoire présente un inconvénient au moment de la programmation. La capacité existante entre drain et source des transistors à grille flottante non adressés provoque un courant de fuite entre ces deux régions. Ce courant de fuite est faible mais il doit être pris en compte au prorata du nombre de points mémoires dont les drains sont reliés à une même ligne de bits. Si ce nombre est trop important la tension de programmation dispensée par la ligne de bits ne peut être maintenue, elle chute. La programmation devient alors impossible.

De plus la technique de réalisation en des niveaux de polysilicium superposés des deux grilles du transistor à grilles flottantes nécessite de définir en trois fois la largeur des grilles flottantes de ces transistors. En effet est définie une première fois au moment de la réalisation de cette grille flottante à un niveau dit POLY 1. Une deuxième définition est réalisée au moment de la définition de la couche d'oxyde dit interpoly devant se placer entre le niveau de POLY 1 et un deuxième niveau de polycilicium dit POLY 2 utilisé pour réaliser les lignes de mot. La troisième définition correspond à la définition en bande des lignes de mot. Ces trois définitions successives doivent être réalisées à l'aplomb l'une de l'autre. Les tolérances d'alignement des différents masques utilisés pour ces trois définitions rendent l'obtention d'une longueur de canal de conduction utile critique. En effet cette longueur est mal maîtrisée du fait de la succesion des nombreuses opérations du procédé de fabrication par lesquelles elle est concernée.

Une EPROM à grille fractionnée, dans laquelle la région de drain du transistor à grille flottante est auto-alignée avec le bord de la grille flottante, est décrite dans EP-A-0 164 781.

L'invention a pour objet de remédier à ces inconvénients en proposant une architecture intime du transistor à grille flottante des cellules mémoires telle que ces problèmes d'alignement disparaissent, de même que les problèmes d'encombrement liés à la présence des transistors de commande. Schématiquement dans l'invention, on structure le transistor à grille flottante de telle manière que sa grille de commande gouverne en partie le canal de conduction de ce transistor. Au moment de la lecture, la partie gouvernée par cette grille de commande tendrait à rendre le transistor conducteur. Mais celui-ci ne devient conducteur que si une autre partie de ce canal de conduction, en série avec celle-ci, et gouvernée par la grille flottante, le permet. On montrera par contre qu'au moment de la programmation la mise sous tension, à tension élevée, de cette grille de commande provoque la mise en saturation de la totalité du canal de conduction d'un point mémoire sélectionné. Les porteurs chauds, les électrons avec un substrat de type P, migrent alors facilement vers la grille flottante.

L'invention concerne donc une mémoire en circuit intégré dans un subtrat semiconducteur du type dont les cellules mémoires sont munies d'un transistor à grille flottante, cette grille flottante étant interposée entre le canal de conduction du transistor et la grille de commande de ce transistor, comme on le definit dans le jeu de revendications ci-joint.

L'invention sera mieux comprise à la lecture de la description qui suit et à l'examen des figures qui l'accompagnent.Celles-ci ne sont données qu'à titre indicatif et nullement limitatif de l'invention. Les figures montrent :
- figure 1 : la représentation schématique d'une mémoire conforme à l'invention;
- figure 2 : une représentation en coupe des régions caractéristiques du subtrat semiconducteur de la figure 1 ;
- figure 3, 4, 5a, 5b, 6a, 6b, 7a et 7b : des coupes des différentes parties du plan mémoire de la mémoire de l'invention à différents stades de fabrication.

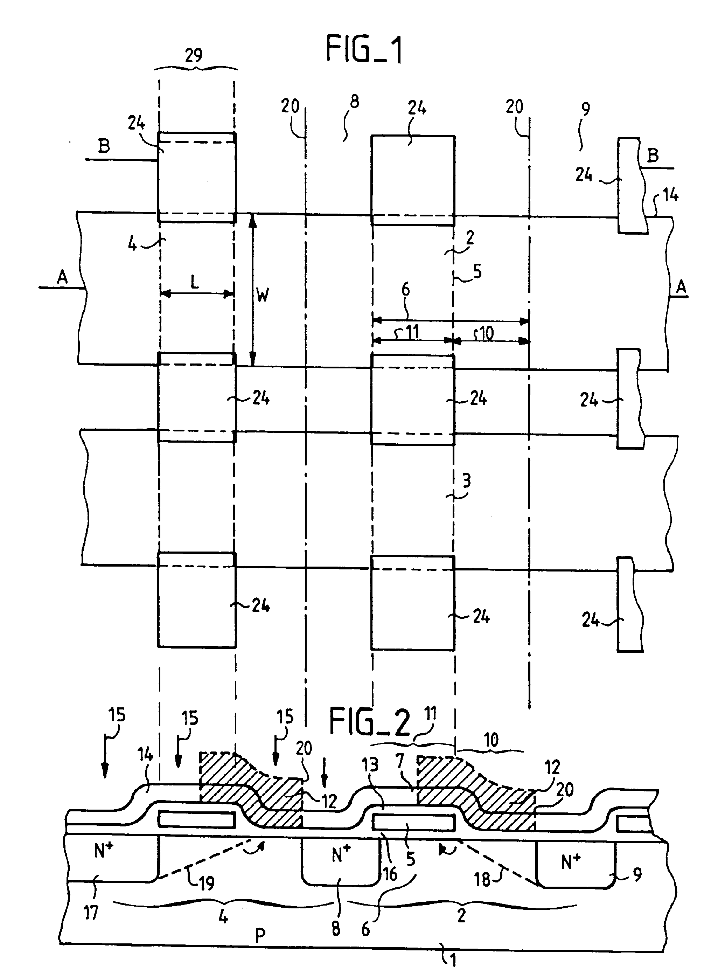

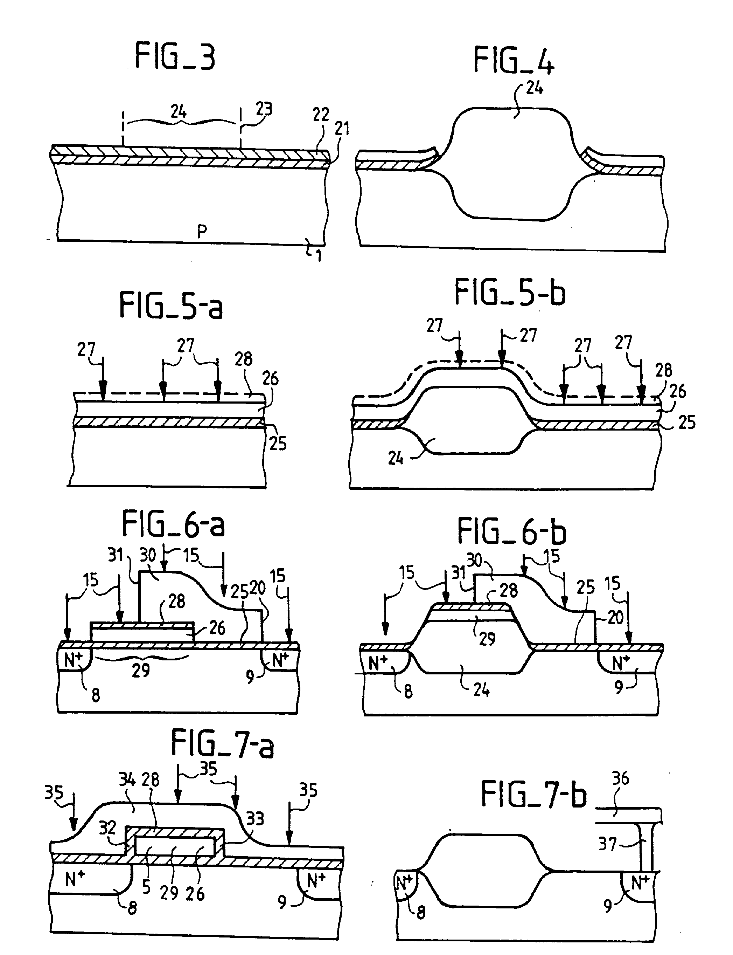

Les figures 1 et 2 représentent une mémoire en circuit intégré selon l'invention. La figure 2 est une coupe, selon le tracé A - A, des cellules mémoires de la figure 1. Dans un subtrat semiconducteur 1 on a réalisé des cellules mémoires telles que 2, 3 ou 4 munies chacune d'un transistor à grille flottante. Cette grille flottante, par exemple la grille flottante 5 du transistor de la cellule mémoire 2, est interposée entre le canal de conduction 6 de ce transistor et la grille de commande 7 de ce transistor. Ce transistor comporte par ailleurs une région de drain 8 et une région de source 9. Ce qui caractérise l'invention est que la grille de commande 7 s'étend seule à aplomb d'une partie 10 de ce canal de conduction 6. La partie 10 est en série, dans le sens de ce canal de conduction, avec une autre partie 11 de ce canal de conduction située, elle, à l'aplomb de la grille flottante 5. Ceci est particulièrement remarquable en examinant la région de source 9 dont l'extrémité de gauche (sur les figures) borde la partie 10 et ne borde pas la partie 11.

Hormis les étapes de procédé de fabrication qui seront décrites plus loin mais qui pourraient en partie être assimilées à des étapes de type classique, le procédé de fabrication de la mémoire de l'invention comporte une étape d'interposition d'une couche de résine 12, montrée par des hachures réalisée après la définition de la couche de polysilicium POLY 1, après la réalisation d'un oxyde interpoly 13, mais avant la réalisation d'une couche 14 de polysilicium de deuxième niveau :POLY2. Le niveau POLY 1 sert à définir les grilles flottantes 5. Le masque constitué par la résine 12 est mis à profit pour implanter par une implantations 1 5, des impuretés de type N+ dans les régions 8 et 9 de drains et sources des transistors à grille flottante.Par exemple les impuretés de type N+ sont des particules de phosphore implantées avec une énergie de l'ordre de 180 KeV de manièree à apporter une concentration de l'ordre de 10 puissance 19 à 10 puissance 20 atomes d'impuretés par centimètre cube dans ces régions. Après cette implantation, la résine 12 est enlevée et la suite du procédé de fabrication est réentreprise normalement.

Le fonctionnement de la cellule mémoire de l'invention est le suivant. Au moment de la programmation de la cellule mémoire 2 le drain 8 du transistor de cette cellule,jouant le rôle de ligne de bits, est porté à un potentiel élevé : par exemple 8 volts. Par contre la source 9 de ce transistor est portée à O volt. La programmation est obtenue en appliquant une tension élevée, par exemple 12 volts, sur la ligne de mot 14 qui conduit à ce transistor 2. L'application de cette haute tension provoque une saturation de la conduction du canal de conduction 6, au moins sur sa partie 11 proche du drain 8 et à l'aplomb de la grille flottante 5. Dans ces conditions les porteurs chauds, des électrons, provenant de la source 9 se trouvent, à l'aplomb de cette partie 11, agités fortement. Certain sont suffisamment agités pour traverser la couche 16 d'oxyde de grille située sous la grille flottante 5 et pour venir s'amasser dans cette grille.

On remarque que cet effet de programmation ne se produit cependant pas pour le transistor 4 voisin, dont la source 17 est également portée à un potentiel nul. En effet, du fait des tensions mises en jeu, l'établissement de la saturation ne se produit qu'à proximité de la région 8 de drain. Les profils de concentration de porteurs 18 et 19 qui prévalent au moment de la mise en saturation des canaux de conduction de ces deux transistors, sont naturellement orientés symétriquement par rapport à la région de drain 8. Or la région 10 en série avec la région 11 du canal 6 d'un transistor n'est pas réalisée symétriquement par rapport à la région du drain 8. En effet, en étant transportée latéralement, translatée, elle constitue une répartition assymétrique des cellules mémoires par rapport à ces régions de drain. Il en résulte que si des porteurs chauds émigrent du canal de conduction du transistor 4, ils ne peuvent le faire que dans une région proche de la région de drain 8. Dans ce cas ils aboutissent directement dans la ligne de mot 14, à l'endroit où celle-ci gouverne les canaux de conduction des transistors voisins. Cette ligne de mot 14 subit un faible courant de fuite. Mais surtout la cellule mémoire 4 n'est pas programmée : c'est ce qu'on voulait.

En ce qui concerne la cellule mémoire 3, placée en dessous de la cellule mémoire 2 sur la figure 1, elle ne peut pas être programmée puisque sa ligne de mot n'est pas soumise à un potentiel élevé mais à un potentiel nul. A l'endroit de la cellule mémoire 3 le phénomène de saturation ne peut pas s'établir puisque la partie 10 du canal de conduction du transistor est bloquée par la tension présente sur cette ligne de mot de ce transistor 3. Le transistor 3 ne conduit donc pas. Il n'est donc pas en saturation. A son endroit les électrons ne peuvent pas quitter la source 9.

Les figures 3 à 7 suivantes représentent des étapes préférées d'un procédé de fabrication d'une cellule mémoire selon l'invention. En particulier on mettra en évidence la limite 20 (figure 1) de réalisation des régions source des transistors à grilles flottantes qui permet l'existence de la région 10 où la grille de commande de ces transistors peut gouverner le canal de conduction. On notera cependant que le caractère répétitif du motif élémentaire du circuit intégré transforme les régions drain et source des transistors en des régions sources et drains de transistors adjaçents. Sur un subtrat 1 par exemple de type P, et dans la région du plan mémoire de la mémoire, on réalise d'abord (figure 3) un oxyde initial dit de piédestal 21 suivi d'un dépôt 22 de nitrure de silicium Si3N4. Par une première opération de photomasquage 23 on délimite des zones 24 d'isolation en oxyde épais. On grave l'épaisseur de nitrure de silicium et on fait croître l'oxyde épais 24. (figure 4) Au moment de la croissance de l'oxyde épais 24, la couche 21 empêche la couche 22 de nitrure de silicium d'induire des efforts mécaniques destructeurs dans le subtrat 1. Dans la pratique on peut faire croître l'oxyde d'isolation 24 jusqu'à une épaisseur de 4000 angströms par exemple. La couche 22 sert de barrière d'oxydation.

L'oxyde 21 et le nitrure 22 sont ensuite dissout, et on réalise ensuite (figures 5a et 5b) une couche 25 d'oxyde de grille sur la totalité du plan mémoire. Les figures cotées "a" se réfèrent à une coupe A A du plan mémoire de la figure 1. Les figures cotées "b" se référent à une coupe B B. L'épaisseur de l'oxyde de grille 25 est de préférence de 100 à 150 angströms. Cette épaisseur est classique, elle peut être facilement maîtrisée. En effet du fait de la disparition du transistor de commande des point mémoires, l'augmentation d'intégration n'a pas à s'exercer au détriment des tailles des transistors à grille flottante et donc de l'épaisseur de leur oxyde de grille. Néanmoins, lorsque la technique aura évolué, ce perfectionnement pourra continuer à être utilisé avec des épaisseurs d'oxyde plus faibles. Après avoir réalisé l'oxyde de grille 25, on dépose sur la totalité du point mémoire une première couche de polycilicium 26 : le niveau POLY 1. Par une opération ultérieure de dopage 27, par exemple au PoC13, on peut augmenter la conductibilité de la couche 26. Le dopage 27 est réalisé sur tout le plan mémoire. Après ce dopage on réalise un oxyde interpoly 28, montré avec des tirets sur les figures 5a et 5 b parce qu'il est réalisé après le dopage 27.

Par une deuxième opération de photomasquage, cette fois au moyen d'un résine, on gave le POLY 1 en bande. Les bandes apparaissent par exemple en 29 sur la figure 1. Le fait que la couche de POLY 1 soit gravée en bande apparait aussi sur les figures 6 en particulier sur la figure 6b où la couche 29 est présente au dessus de l'oxyde épais 24. La présence de cette couche 29 là ou elle semble inutile est liée aux raison suivantes. Si on définit les grilles flottantes immédiatement comme des surfaces fermées, les contours de ces surfaces s'arrondiront au fur et à mesure de la réalisation des autres étapes du procédé. En définitive les grilles flottantes ne seront plus définies avec des angles vifs mais avec des contours arrondis. Ceci limite les surfaces de couplage entre les deux grilles, grille flottante - grille de commande, et est néfaste au bon fonctionnement du point mémoire. Au moment de la gravure des bandes 29 on est capable de graver l'oxyde interpoly 28 et la couche de POLY 1 sans graver la couche 25 d'oxyde de grille. En définitive les bandes 29 correspondent aux parties 11 des canaux de conduction des transistors des point mémoires.

Une fois que cette opération de gravure du POLY 1 est terminée, on réalise en une troisième opération de photomasquage, une couche de résine 30 qui détermine par un de ses flancs 20 la limite de la région 10 du canal de conduction qui sera affectée au gouvernement de la grille de commande. Par son autre extrémité 31 le masque utilisé pour réaliser la couche de résine 30 doit arriver en une position moyenne au-dessus des bandes 29. La position du flanc 31 n'a pas besoin d'être réglée avec une grande précision. On pourrait montrer d'ailleurs que la position du flanc 20 n'est pas non plus très critique. Après la réalisation de la couche de résine 30 on réalise l'implantation 15 des drains 8 et sources 9. Cette implantation est auto-alignée d'une part sur les bandes 29 du POLY 1 et sur le flanc 20 de la couche 30.

Après cette implantation on enlève la couche 30 et on oxyde (figure 7a) les flancs 32 et 33 du POLY 1. Au besoin cette oxydation des flancs 32 et 33 peut être mise à profit pour réajuster l'épaisseur de l'oxyde de grille qui aurait été trop gravé au moment de la définition des bandes 29 du POLY 1. Puis on dépose la couche du POLY 2 34 que l'on dope par une opération 35 de la même façon que pour le POLY 1. Par une opération supplémentaire de photomasquage on définit le POLY 2 et on le gave. Cette gravure est cependant plus profonde pour graver en même temps l'oxyde interpoly 28 ainsi que le POLY 1 dont on détermine ainsi définitivement les contours avec des angles vifs. Les figures 7a et 7b montrent respectivement les états de la surface des points mémoires après cette gravure. Il n'y a plus de POLY 2 au droit de la coupe BB. Au droit de la coupe AA le POLY 2 constitue la ligne de mot 14 qui, de place en place, agit elle-même comme grille de commande. Le reste du procédé est classique et ne nécessite pas d'être énoncé ici.

Néanmoins, dans ces opérations classiques il est connu de réaliser ultérieurement, à l'aplomb des régions actives 8 et 9 des transistors, des lignes de bits métallisées 36. Dans l'état de la technique cité, dans le but de réduire le nombre des mises en contact de ces lignes métallisées avec ces régions actives, les transistors à grille flottante de points mémoires adjacents sont associés par leur drain (ou par leur source en fonction de la polarité). Il faut donc trois prises pour deux transistors voisins : soit une fois et demie le nombre des cellules mémoires. Du fait de la structure particulière de la réalisation des point mémoires de l'invention on se rend compte que le drain d'un transistor est la source d'un transistor latéralement voisin, et vice et versa. Les régions drains et sources traversent le plan de la mémoire parallèlement les unes aux autres. En outre du fait que les drains 8 et sources 9 traversent tout le plan mémoire, sans interruption par des régions d'oxyde épais, il devient possible de ne relier une ligne de bits métallisée que de loin en loin à ces régions actives 8 et 9. Par exemple il suffit de ne réaliser une prise 37 de contact de ligne de bit métallisée que tous les 16 ou 32 cellules mémoires. Compte tenu de la place perdue en mémoire par les prises de contact, cette particularité, liée à l'absence du transistor de commande, est tout à fait favorable à l'augmentation des capacités d'intégration.

## Revendications

1. Mémoire en circuit intégré dans un substrat (1) semiconducteur du type dont les cellules (2) mémoires sont munies de transistor à grille (5) flottante, ces transistors à grille flottante ayant des régions sources et drains placées de part et d'autre d'un canal de conduction, la grille flottante étant interposée entre ce canal (6) de conduction du transistor et une grille (7) de commande de ce transistor, ce canal de conduction ayant une largeur et une longueur, cette longueur étant perpendiculaire à cette largeur, ce canal de conduction ayant une première et une deuxième partie adjacentes l'une à l'autre par un bord commun, ce bord commun étant perpendiculaire à ladite longueur, la grille de commande de ce transistor s'étendant seule à l'aplomb de la première partie (10) du canal de conduction, et s'étendant, au dessus de la grille flottante, à l'aplomb de la deuxième partie, cette première partie étant en série, dans le sens de la conduction du canal de conduction, avec la deuxième partie (11) de ce canal de conduction, un oxyde de grille étant présent entre cette première partie du canal de conduction et la grille de commande et également entre cette deuxième partie du canal de conduction et la grille flottante, les cellules étant disposées aux croisements d'alignements de grilles en polysilicium (29) d'un premier niveau, servant à réaliser les grilles flottantes, avec des lignes de polysilicium (14) d'un deuxième niveau, servant de grilles de commande, ces alignements et lignes étant sensiblement perpendiculaires les uns aux autres, les lignes des grilles de commande étant parallèles aux longueurs des canaux de conduction, les régions sources et drains étant implantées par autoalignement sur un bord desdites grilles flottantes, caractérisée en ce que l'oxyde de grille a une épaisseur inférieure à 15 nm (150 angströms), et en ce que les largeurs des canaux de conduction des cellules sont limitées par deux régions d'oxyde épais (24) en îlots, les canaux de conductions de deux cellules voisines étant séparés, dans le sens de la largeur de ces canaux, par un îlot, les îlots étant bordés par une desdites régions de drains ou sources et par lesdites lignes des grilles de commande.

2. Mémoire selon la revendication 1 caractérisée en ce que les cellules mémoires comportent des lignes de bits métallisées (36) pour accéder à des régions de drains et sources des cellules mémoires, et en ce que ces lignes de bits métallisées accèdent (37) à ces cellules mémoires au plus une fois tous les quatre cellules mémoires.

3. Mémoire selon l'une quelconque des revendications 1 ou 2, caractérisée en ce que la grille flottante est définie avec des angles vifs.

4. Mémoire selon l'une quelconque des revendications 3 ou 4 caractérisée en ce que les régions drains (8) et sources (9) des cellules mémoires traversent parallèlement l'une à l'autre le plan des cellules mémoires de la mémoire.

## Patentansprüche

1. Speicher mit integrierter Schaltung in einem Halbleitersubstrat (1) des Typs, bei dem die Speicherzellen (2) mit Transistor mit schwebendem Gate (5) versehen sind, wobei die Transistoren mit schwebendem Gate auf beiden Seiten eines Leitungskanals angeordnete Source- und Drainbereiche aufweisen, wobei das schwebende Gate zwischen dem Leitungskanal (6) des Transistors und einem Steuergate (7) des Transistors geschaltet ist, wobei der Leitungskanal eine Breite und eine Länge aufweist, wobei die Länge senkrecht zur Breite ist, wobei der Leitungskanal einen ersten und einen zweiten Teil, mittels eines gemeinsamen Randes einander benachbart, aufweist, wobei der gemeinsame Rand senkrecht zur Länge ist, wobei sich das Steuergate des Transistors allein in der Senkrechten des ersten Teils (10) des Leitungskanals erstreckt und sich oberhalb des schwebenden Gates in der Senkrechten des zweiten Teils erstreckt, wobei sich der erste Teil in der Richtung der Leitung des Leitungskanals in Reihe mit dem zweiten Teil (11) des Leitungskanals befindet, wobei zwischen dem ersten Teil des Leitungskanals und dem Steuergate und ebenso zwischen dem zweiten Teil des Leitungskanals und dem schwebenden Gate ein Gateoxid vorhanden ist, wobei die Zellen bei den Fluchtlinienkreuzungspunkten von Polysiliciumgates (29) eines ersten Niveaus, die zur Ausfuhrung der schwebenden Gates dienen, mit Polysiliciumlinien (14) eines zweiten Niveaus, die als Steuergates dienen, angeordnet sind, wobei die Fluchtlinien und Linien im wesentlichen senkrecht zueinander sind, wobei die Linien der Steuergates parallel zu den Längen der Leitungskanäle sind, wobei die Source- und Drainbereiche durch Selbstausrichtung auf einem Rand der schwebenden Gates implantiert sind, dadurch **gekennzeichnet**, daß das Gateoxid eine Dicke kleiner als 15 nm (150 Angström) aufweist und daß die Breiten der Leitungskanäle der Zellen durch zwei dicke Oxidbereiche (24) als Inseln begrenzt sind, wobei die Leitungskanäle von zwei benachbarten Zellen in der Richtung der Breite der Kanäle durch eine Insel getrennt sind, wobei die Inseln durch einen der Drain- oder Sourcebereiche und durch die Linien der Steuergates begrenzt sind.

2. Speicher nach Anspruch 1, dadurch **gekennzeichnet**, daß die Speicherzellen metallisierte Bitreihen (36) zum Zugreifen auf Drain- und Sourcebereiche der Speicherzellen umfassen und daß die metallisierten Bitreihen auf die Speicherzellen höchstens einmal für sämtliche vier Speicherzellen zugreifen (37).

3. Speicher nach einem beliebigen der Ansprüche 1 oder 2, dadurch **gekennzeichnet**, daß das schwebende Gate mit Spitzen Winkeln abgegrenzt ist.

4. Speicher nach einem beliebigen der Ansprüche 3 oder 4, dadurch **gekennzeichnet**, daß die Drain- (8) und Source- (9) -Bereiche der Speicherzellen die Ebene der Speicherzellen des Speichers parallel zueinander durchqueren.

## Claims

1. Integrated-circuit memory in a semiconductor substrate (1), of the type whose memory cells (2) are provided with a floating-gate transistor, these floating-gate transistors having source and drain regions placed on each side of a conducting channel, the floating gate being interposed between this conducting channel (6) of the transistor and a control gate (7) of this transistor, this conducting channel having a width and a length, this length being perpendicular to this width, this conducting channel having a first part and a second part adjacent to each other through a common edge, this common edge being perpendicular to the said length, the control gate of this transistor extending alone in line with the first part (10) of the conducting channel and extending, above the floating gate, in line with the second part, this first part being in series, with reference to the conduction of the conducting channel, with the second part (11) of this conducting channel, a gate oxide being present between this first part of the conducting channel and the control gate and also between this second part of the conducting channel and the floating gate, the cells being disposed at the intersections of polysilicon gate alignments (29) on a first level, serving to produce the floating gates, with polysilicon lines (14) on a second level, serving as control gates, these alignments and lines being substantially perpendicular to each other, the lines of the control gates being parallel to the lengths of the conducting channels, the source and drain regions being implanted by self-alignment on an edge of the said floating gates, characterised in that the gate oxide has a thickness of less than 15 nm (150 angstroms) and in that the widths of the conducting channels of the cells are defined by two thick oxide regions (24) in islands, the conducting channels of two neighbouring cells being separated, in the direction of the width of the channels, by an island, the islands being bordered by one of the said drain or source regions and by the said lines of the control gates.

2. Memory according to Claim 1, characterised in that the memory cells have metallised bit lines (36) to provide access to drain and source regions of the memory cells, and in that these metallised bit lines provide access (37) to these memory cells at most once every four memory cells.

3. Memory according to either one of Claims 1 or 2, characterised in that the floating gate is defined with acute angles.

4. Memory according to either one of Claims 3 or 4, characterised in that the drain (8) and source (9) regions of the memory cells pass, parallel to each other, through the plane of the memory cells of the memory.
